(19) Europäisches Patentamt
European Patent Office
Office européen des brevets

(11) **EP 3 849 140 B1**

(12) **EUROPEAN PATENT SPECIFICATION**

(45) Date of publication and mention
of the grant of the patent:
**24.04.2024 Bulletin 2024/17**

(21) Application number: **21150455.0**

(22) Date of filing: **07.01.2021**

(51) International Patent Classification (IPC):
*H04L 41/147* (2022.01)     *H04L 41/14* (2022.01)

(52) Cooperative Patent Classification (CPC):
**H04L 41/147; H04L 41/145**

(54) **DATA REPORTING METHOD AND RELATED DEVICE**

DATENMELDEVERFAHREN UND ZUGEHÖRIGE VORRICHTUNG

PROCÉDÉ DE RAPPORT DE DONNÉES ET DISPOSITIF ASSOCIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **10.01.2020 CN 202010027285**

(43) Date of publication of application:
**14.07.2021 Bulletin 2021/28**

(73) Proprietor: **HUAWEI TECHNOLOGIES CO., LTD.
Shenzhen, Guangdong 518129 (CN)**

(72) Inventors:
• **SU, Di**
**SHENZHEN, Guangdong 518129 (CN)**
• **CHEN, Rui**
**SHENZHEN, Guangdong 518129 (CN)**
• **DAI, Xinning**
**SHENZHEN, Guangdong 518129 (CN)**

(74) Representative: **Körber, Martin Hans et al
Mitscherlich PartmbB
Patent- und Rechtsanwälte
Karlstraße 7
80333 München (DE)**

(56) References cited:
**EP-A2- 2 045 673     US-A1- 2002 099 821**

## Description

### TECHNICAL FIELD

This application relates to the network monitoring field, and in particular, to a data reporting method and a related device.

### BACKGROUND

Network monitoring refers to surveillance and control of network devices (such as computers and mobile phones) in the local area network. Conventional network monitoring methods such as the simple network management protocol (Simple Network Management Protocol, SNMP) mode and the command-line interface (Command-Line Interface, CLI) mode mainly include the following deficiencies: (1) The network management device obtains the monitoring data of the network device in a pull mode, and consequently cannot monitor a large quantity of network devices at the same time, limiting the network growth. (2) The accuracy of obtaining the monitoring data is at the minute level. The obtaining accuracy can be improved only by increasing the frequency of querying the network device, but this results in high usage of the central processing unit (central processing unit, CPU) of the network device, and thus affects the normal operation of the network device. (3) Due to the network transmission delay, the accuracy of the obtained network device monitoring data is affected.

To resolve the foregoing problems, the network telemetry (Telemetry) technology has emerged. The network telemetry technology can meet the needs of large-scale and high-performance network monitoring. In the network telemetry technology, there are mainly two methods in which the network device reports the monitoring data to the network management device: (1) periodic reporting, that is, the network device reports its data in the current period to the network management device based on the preset period; (2) threshold-based reporting, that is, triggered reporting, which means that when data of the network device exceeds a threshold range, the network device reports the abnormal data.

The foregoing data reporting methods have the following problems: In the periodic reporting method, a large amount of data is reported, and a large quantity of CPU, memory, and network bandwidth of the network device is occupied, thereby increasing the reporting burden. In the threshold-based reporting method, only abnormal data is reported, and the network management device cannot obtain the change status of the data within the threshold range in the network device US 2002/099821 A1 relates to operations and management of networked systems, particularly to acquiring measurements of computer and communications systems in distributed environments. EP 2 045 673 A2 relates to process control systems, more particularly, to a system architecture for process model identification and application in adaptive process control systems.

### SUMMARY

A first aspect of this application provides a data reporting method according to independent claim 1 and a related device according to independent claim 8. Additional features of the application are provided in the dependent claims. In the following, parts of the description and drawings referring to embodiments which are not covered by the claims are not presented as embodiments of the application, but as examples useful for understanding the application The method can be used in the network monitoring field, so that a network management device can predict a trend status of true monitoring data on a network device only based on a model and a value of a parameter included in the model, and the network device reports only an identifier of the model and a value of a corresponding parameter in the model. This effectively reduces an amount of data reported by the network device, alleviates bandwidth pressure, and reduces data backhaul bandwidth.

Based on this, embodiments of this application provide the following technical solutions:

According to a first aspect, an embodiment of this application provides a data reporting method. The method specifically includes: first, a first device (such as one of a network management device and a network device) obtains a sampled-data set within a preset period. The sampled-data set includes a plurality of pieces of sampled data, and the obtained sampled-data set refers to a plurality of pieces of sampled data obtained within sampling duration corresponding to the preset period. For example, the preset period is set to obtain a sampled-data set once every 10 minutes, and the obtained sampled-data set is data collected in the current 10 minutes. It should be noted that the preset period can be set according to needs, which is not specifically limited herein. Then, the first device obtains a first model and a value of a parameter included in the first model from a model set based on the sampled-data set obtained above. The model set includes one or more models supported by both the first device and a second device (such as the other one of the network management device and the network device). Finally, the first device sends an identifier of the determined first model (that is, a model identifier) and the value of the parameter of the first model to the second device. If the first model exists in the second device, the second device can identify a corresponding model on the second device based on the identifier, and then substitute the value of the corresponding parameter into the model.

In the foregoing embodiments of this application, because both the first device and the second device have the model and the value of the parameter included in the model, the first device or the second device can predict subsequent monitoring data based on the model and the value of the parameter included in the model, so as to understand a trend status of the true monitoring data.

With reference to the first aspect of the embodiments of this application, in a first implementation of the first aspect of the embodiments of this application, that the first device obtains the first model and the value of the parameter included in the first model from the model set based on the sampled-data set is

specifically implemented in following manner: First, the first device obtains a first data set and a second data set from the sampled-data set according to a preset algorithm. The first data set and the second data set each includes at least one of a plurality of pieces of sampled data. The first data set is used to train the model, and the second data set is used to verify accuracy of the model. Then, each piece of sampled data in the first data set is used as training data to train each model in the model set (any model in the model set may be referred to as a second model at this time), so as to obtain the value of the parameter included in each model. Each piece of sampled data in the second data set is used as verification data to verify accuracy of a model for which the value of the parameter has been determined, that is, to verify a deviation corresponding to each model. In other words, the sampled data in the second data set is input into each model to obtain predicted data. In this way, it is compared whether the sum of differences between the predicted data obtained by each model and the true actual data is less than a preset value. Finally, if the model set includes a model whose corresponding deviation is less than the preset value, the first device uses the model as the first model described above, and a value of a parameter included in the model is the value of the parameter included in the first model.

As described in the foregoing embodiment of this application, that the first device obtains the first model and the value of the parameter included in the first model from the model set based on the sampled-data set can be specifically implemented in the following manner: The sampled-data set is used to first train and then verify each model in the model set, and the model whose corresponding deviation is less than the preset value is selected as the first model. This provides flexibility.

## BRIEF DESCRIPTION OF DRAWINGS

FIG. 1 is a schematic diagram of a static telemetry subscription service process;
FIG. 2 is a schematic diagram of a dynamic telemetry subscription service process;
FIG. 3 is a schematic diagram of a data reporting method according to an embodiment of this application;
FIG. 4 is a schematic diagram of an architecture of a network monitoring system according to this application;
FIG. 5 is a schematic diagram of a specific implementation of a data reporting method according to an embodiment of this application;
FIG. 6 is a schematic flowchart of a specific implementation of a data reporting method according to an embodiment of this application;
FIG. 7 is a schematic diagram of a comparison between a model reporting method in this application and a periodic reporting method and a threshold-based reporting method;
FIG. 8 is another schematic diagram of a specific implementation of a data reporting method according to an embodiment of this application;
FIG. 9 is a schematic diagram of a first device according to an embodiment of this application; and
FIG. 10 is a schematic diagram of a related device according to an embodiment of this application.

## DESCRIPTION OF EMBODIMENTS

Embodiments of this application provide a data reporting method and a related device, so as to determine a model and a value of a parameter included in the model only through exchange of a sampled-data set in a preset period between a first device (for example, one of a network management device and a network device) and a second device (for example, the other one of a network management device and a network device), and finally predict a trend status of true monitoring data on the network device directly based on the model and the value of the parameter included in the model, thereby effectively reducing an amount of reported data and alleviating bandwidth pressure.

The following describes the embodiments of this application with reference to accompanying drawings. A person of ordinary skill in the art may learn that as a technology develops and a new scenario emerges, technical solutions provided in the embodiments of this application are also applicable to a similar technical problem.

In this specification, the claims, and the accompanying drawings of this application, the terms "first", "second", and on the like are intended to distinguish between similar objects but do not necessarily indicate a specific order or sequence. It should be understood that the terms used in such a way are interchangeable in proper cases, which is merely a distinguishing manner used when objects having a same attribute are described in the embodiments of this application. In addition, the terms "include", "contain" and any other variants mean to cover the non-exclusive inclusion, so that a process, method, system, product, or device that includes a series of units is not necessarily limited to those units, but may include other units not expressly listed or inherent to such a process, method, system, product, or device.

Before the embodiments are described, concepts that may be used in the embodiments of this application are first described. It should be understood that explanations of related concepts may be limited due to specific situations of the embodiments of this application, but it does not mean that this application can only be limited to the specific situations. There may be differences in the specific situations of different embodiments. Details are not limited herein.

Telemetry: literally translated as a network telemetry technology. It is mainly responsible for key data such as resource usage of each component in a system. For example, telemetry can provide real-time monitoring data for a network monitoring system. The monitoring data may specifically include cloud server usage data, block storage/object storage data, network related data including bandwidth/routing and the like, user management/authentication related data, and the like. The network telemetry technology can support the system in managing more devices. The monitoring data obtained through this technology is more accurate and more real-time, and a monitoring process has slight impact on a function and performance of the device. The network telemetry technology provides most important big data foundation for quickly locating a network problem, and optimizing and adjusting network quality. Specific application of the network telemetry technology in the network monitoring system may include static telemetry subscription and dynamic telemetry subscription.

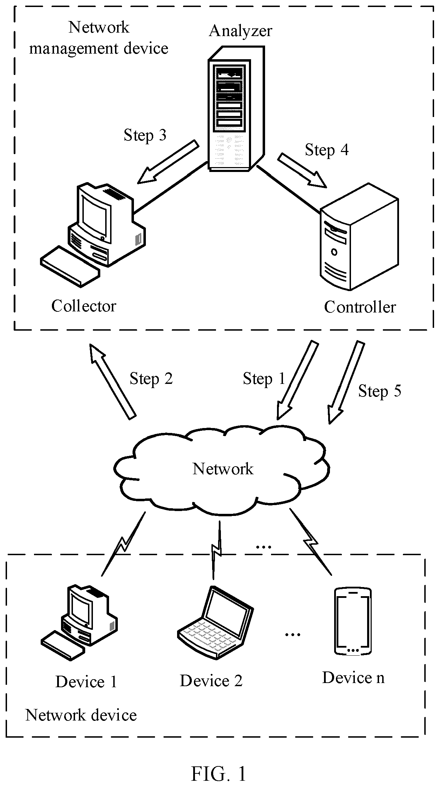

Static telemetry subscription: Static telemetry subscription means that a network device serves as a client and a collector in a network management device serves as a server, and the network device actively initiates a connection to the collector to collect and upload monitoring data. For a specific service process, refer to FIG. 1. The static telemetry subscription service process includes five steps. Step 1 is a dynamic configuration stage: A controller in the network management device configures a network device (for example, device 1, device 2, ... , device n in FIG. 1) supporting telemetry through a command line, subscribes to a data source, and completes data collection. Step 2 is a sampled data or custom event pushing stage: The network device reports, based on a configuration requirement of the controller, the collected data or custom event to the collector for receiving and storage. Step 3 is a data reading stage: An analyzer in the network management device reads the sampled data or the custom event stored in the collector. Step 4 is a data analysis stage: The analyzer analyzes the read sampled data or custom event, and sends an analysis result to the controller, so that the controller performs configuration management for a network and optimizes the network in a timely manner. Step 5 is a network parameter adjustment stage: The controller sends a network configuration that needs to be adjusted to the network device. After the configuration is sent and takes effect, new sampled data or a new custom event is continuously reported to the collector. At this time, the network device can analyze whether a network effect after the optimization meets an expectation, until the optimization is completed and the entire service process forms a closed loop.

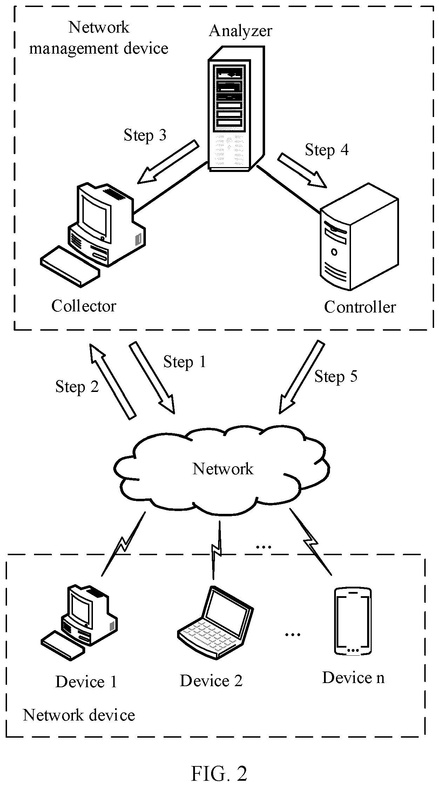

Dynamic telemetry subscription: Dynamic telemetry subscription means that a network device serves as a server, and a collector in a network management device serves as a client and initiates a connection to the network device; the network device collects and uploads monitoring data. For a specific service process, refer to FIG. 2. The dynamic telemetry subscription service process includes five steps. Step 1 is a dynamic configuration stage: After a related configuration for a network device (for example, device 1, device 2, ..., device n in FIG. 2) supporting telemetry is completed, the collector sends a dynamic configuration to the network device to complete data collection. Step 2 is a sampled data or custom event pushing stage: The network device reports, based on a configuration requirement of the collector, the collected data or custom event to the collector for receiving and storage. Step 3 is a data reading stage: An analyzer in the network management device reads the sampled data stored in the collector. Step 4 is a data analysis stage: The analyzer in the network management device analyzes the read sampled data, and sends an analysis result to the controller, so that the controller performs configuration management for a network and optimizes the network in a timely manner. Step 5 is a network parameter adjustment stage: The controller sends a network configuration that needs to be adjusted to the network device. After the configuration is sent and takes effect, new sampled data is reported to the collector. At this time, the network management device can analyze whether a network effect after the optimization meets an expectation, until the optimization is completed and the entire service process forms a closed loop.

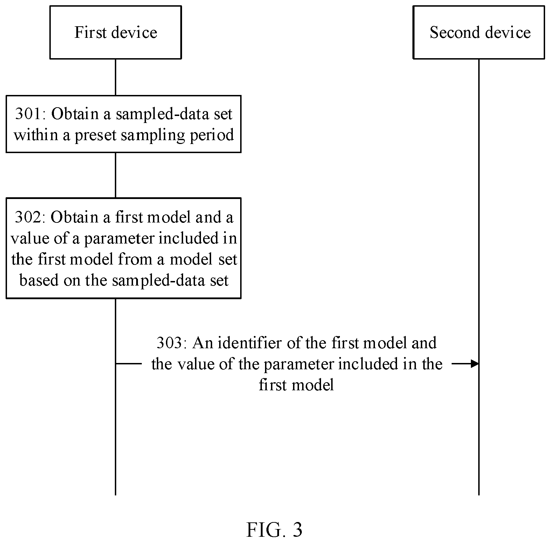

The existing methods for reporting the monitoring data of the network device supporting telemetry (that is, the foregoing periodic reporting and threshold-based reporting) are completed based on static telemetry subscription or dynamic telemetry subscription. Among the foregoing data reporting methods, in the periodic reporting method, a large amount of data is reported, and a large quantity of CPU, memory, and network bandwidth of the network device is occupied, thereby increasing the reporting burden; in the threshold-based reporting method, only abnormal data is reported, and the network management device cannot obtain the change status of the data within the threshold range in the network device. Based on this, an embodiment of this application first provides a data reporting method. For details, refer to FIG. 3.

301. A first device obtains a sampled-data set within a preset sampling period.

First, the first device (such as one of a network management device and a network device) obtains a sampled-data set within the preset period. The sampled-data set includes a plurality of pieces of sampled data, and the obtained sampled-data set refers to a plurality of pieces of sampled data obtained within sampling duration corresponding to the preset period. For example, the preset period is set to obtain a sampled-data set once every 10 minutes, and the obtained sampled-data set is data collected in the current 10 minutes. It should be noted that the preset period can be set according to needs, which is not specifically limited herein.

It should be noted that, in some embodiments of this application, if the first device is a network management device and the second device is a network device, the method in which the first device obtains the sampled-data set within the preset sampling period may be that the second device collects the sampled-data set and reports it to the first device; if the first device is a network device and the second device is a network management device, the method in which the first device obtains the sampled-data set within the preset sampling period may be that the first device directly collects the sampled-data set. In other words, the method in which the first device obtains the sampled-data set varies based on the type of the first device. How the first device obtains the sampled-data set within the preset sampling period is not specifically limited herein.

302. The first device obtains a first model and a value of a parameter included in the first model from a model set based on the sampled-data set.

Then, the first device obtains the first model and the value of the parameter included in the first model from the model set based on the sampled-data set obtained above. The model set includes one or more models supported by both the first device and a second device (such as the other one of the network management device and the network device). For example, first, the first device determines information about the models (such as a model type, a quantity of models, and a model identifier) supported by both the first device and the second device, and determines the information about these models as a model set. After obtaining the sampled-data set, the first device applies the sampled-data set to each model in the model set to obtain the value of the parameter included in each model, and then determines a model (that is, a first model) that meets a requirement (for example, an overall deviation between predicted data and true data is smallest, or a value of a parameter included in the model is smallest) from various models according to needs, and the value of the parameter included in the first model.

It should be noted that, because the models on the first device and the second device may be not completely the same (for example, a model on the first device does not exist on the second device), the models on the first device and the second device need to be synchronized in this case. When the types of the first device and the second device are different, the synchronization methods are also different. The following provides separate descriptions.

a. The first device is a network device and the second device is a network management device.

In this case, first, the first device determines one or more models (which may be referred to as a first candidate model set) supported by the first device, and sends the first candidate model set to the second device; then, the second device determines, based on the first candidate model set and a second candidate model set, one or more models (that is, the foregoing model set) that need to be synchronized to the first device, where the second candidate model set is the model supported by the second device; finally, the second device sends the model set and an identifier of each model (that is, a model identifier) in the model set to the first device, so that the first device and the second device each have the same model set and the same identifier of each model in the model set, and the model identifier can be used to identify a specific expression form of the model.

b. The first device is a network management device and the second device is a network device.

In this case, because the step of obtaining the first model is performed by the first device, the first device only needs to determine one or more models (that is, the foregoing model set) supported by both the first device and the second device. Each model in the model set and the identifier of each model in the model set exist on the first device. Whether the model set exists on the second device is not limited. If the first model exists on the second device, the first device only needs to send the identifier of the first model to the second device subsequently. If the first model does not exist on the second device, after determining the first model, the first device can send the first model and the identifier of the first model to the second device.

It should be further noted that, in some embodiments of this application, that the first device obtains the first model and the value of the parameter included in the first model from the model set based on the sampled-data set can also be specifically implemented in the following manners:

> a. The sampled-data set is used to first train and then verify each model in the model set, and the model whose corresponding deviation is less than a preset value is selected as the first model.

First, the first device obtains a first data set and a second data set from the sampled-data set according to a preset algorithm. The first data set and the second data set each includes at least one of a plurality of pieces of sampled data. The first data set is used to train the model, and the second data set is used to verify accuracy of the model. For example, the preset algorithm may divide, according to a preset ratio (for example, 7:3 and 5:5), the sampled data in the sampled-data set into the first data set (for example, an amount of sampled data in the first data set accounts for 70% and 50%) and the second data set (for example, an amount of sampled data in the second data set accounts for 30% and 50%). Alternatively, the preset algorithm may select sampled data obtained within a middle time segment of the preset period in the sampled-data set as the first data set (for example, if the preset period is 10 minutes, the middle time segment refers to duration ranging from the 3rd to the 7th minutes; and the sampled data obtained within the middle time segment is data collected within the duration ranging from the 3rd to the 7th minutes), and select sampled data obtained within the first and the last time segments of the preset period in the sampled-data set as the second data set (for example, if the preset period is 10 minutes, the first and the last time segments refer to duration ranging from the 1st to the 2nd minutes, and duration ranging from the 8th to the 10th minutes, respectively; and the sampled data obtained within the first and the last time segments is data collected within the duration ranging from the 1st to the 2nd minutes, and the duration ranging from the 8th to the 10th minutes). Details about how to obtain the first data set and the second data set from the sampled-data set according to the preset algorithm are not limited in the embodiment of this application.

Then, each piece of sampled data in the first data set is used as training data to train each model in the model set (any model in the model set may be referred to as a second model at this time), so as to obtain the value of the parameter included in each model. Each piece of sampled data in the second data set is used as verification data to verify accuracy of a model for which the value of the parameter has been determined, that is, to verify a deviation corresponding to each model. In other words, the sampled data in the second data set is input into each model to obtain predicted data. In this way, it is compared whether the sum of differences between the predicted data obtained by each model and the true actual data is less than a preset value. A smaller sum of the differences indicates a smaller deviation corresponding to the model. On the contrary, a larger sum of the differences indicates a larger deviation corresponding to the model. It should be noted that the deviation corresponding to the model refers to the sum of the deviations between the actual data and the predicted data calculated after each piece of sampled data in the second data set is substituted into the model. It is possible that the differences between various pieces of predicted data and the actual data are first calculated and then an average value is calculated. It is also possible that ratios between various pieces of predicted data and the actual data are first calculated and then an average value is calculated. It is also possible that ratios between the differences (that is, the differences between various pieces of predicted data and the actual data) and the actual data are first calculated and then an average value is calculated. A specific representation of the deviation corresponding to the model is not specifically limited herein. In addition, it should be further noted that the preset value is also set according to needs of a user. If high accuracy is required, the preset value may be set to a smaller value. If the required accuracy is not high, the preset value may be set to a larger value. Details are not limited herein.

Finally, if the model set includes only one model whose corresponding deviation is less than the preset value, the first device uses the model as the first model described above, and a value of a parameter included in the model is used as the value of the parameter included in the first model; if the model set includes at least two models whose corresponding deviations are less than the preset value, the first device can determine one model from the foregoing at least two models as the first model in a plurality of manners. For example, the first device can randomly select one of the models as the first model, select a model with a smallest quantity of parameters or a smallest value of a parameter as the first model, or select a model with a smallest corresponding deviation as the first model. Details about how the first device selects one model from a plurality of models whose deviations are all less than the preset value are not specifically limited herein.

To facilitate the understanding of the foregoing method for determining the first model and the value of the parameter included in the first model, examples are used herein for description. It is assumed that the first device is a network management device, the second device is a network device, and the model set supported by both the first device and the second device includes three model function expressions: $y = k * x$, $y = p * x + q$, and $y = a * x^2 + b * x + c$. In the three model functions, x is referred to as an independent variable or domain; y is referred to as a dependent variable or range; k, p, q, a, b, c are parameters of the three model functions respectively. If the sampled-data set obtained by the second device in the preset period includes eight pieces of sampled data: (1, 2), (2, 4), (2, 5), (3, 6), (4, 8), (6, 12), (7, 14), and (8, 15), the second device reports the collected sampled-data set to the first device, and the first device divides the sampled-data set into a first data set and a second data set according to a ratio of 5:5. The first data set includes four pieces of sampled data: (1, 2), (2, 4), (2, 5), and (3, 6), and the second data set includes four pieces of sampled data: (4, 8), (6, 12), (7, 14), and (8, 15). Then, the first device uses abscissa data and ordinate data of the four pieces of sampled data (1, 2), (2, 4), (2, 5), and (3, 6) in the first data set respectively as independent and dependent variables of the foregoing three model functions, to calculate values of various parameters (that is, k, p, q, a, b, c). After the values of the parameters of each model are obtained, the four pieces of sampled data (4, 8), (6, 12), (7, 14), and (8, 15) in the second data set are used to verify whether the foregoing model is feasible, that is, verify whether the value of the parameter included in the model is appropriate and whether the deviation of the model is within an acceptable deviation range. The model function $y = k * x$ is used as an example. The sampled data (1, 2), (2, 4), (2, 5), and (3, 6) in the first data set are substituted into the model function to calculate k = 2, and then the sampled data (4, 8), (6, 12), (7, 14), and (8, 15) in the second data set are substituted into $y = 2x$ to verify whether the model is appropriate. When x = 4 (or 6, 7), predicted data obtained through the model is y = 8. In this case, the actual data is also y = 8 (or 12, 14), indicating that there is no deviation in the model for this sampled data. When x = 8, predicted data obtained through the model is y = 16. In this case, the actual data is y = 15, indicating that there is a specific deviation in the model for this sampled data. If the deviation corresponding to the model is set to indicate that ratios between the differences (that is, the differences between various pieces of predicted data and the actual data) and the actual data are first calculated and then an average value (which may also be referred to as a deviation percentage) is calculated, the deviation percentage is (0/8)+(0/12)+(0/14)+(1/15)=6.7%. Similarly, values of parameters included in the two models $y = p * x + q$ and $y = a * x^2 + b * x + c$, and deviation percentages corresponding to the models can also be calculated by using the method in the foregoing example (details are not described herein). It is assumed that the calculated deviation percentage of $y = p * x + q$ is 8.0%, and the calculated deviation percentage of $y = a * x^2 + b * x + c$ is 9.5%. If the preset value is 7.0%, only the deviation percentage corresponding to $y = 2x$ is less than the preset value (that is, 6.7% < 7.0%), and y = 2x is determined as the first model described above, and parameter 2 is the value of the parameter included in the first model. If the preset value is 9.0%, the deviation percentages corresponding to the two models $y = 2x$ and $y = p * x + q$ are both less than the preset value (that is, 6.7% < 9.0% and 8.0% < 9.0%). In this case, one model may be randomly selected from these two models as the first model, or y = 2x with a lower deviation percentage may be selected as the first model, or $y = p * x + q$ with a larger quantity of parameters may be selected as the first model. A specific selection method is not limited.

b. The sampled-data set is used to first train and then verify each model in the model set, and the model with a smallest corresponding deviation value is selected as the first model.

In this manner, the first device also needs to first obtain the first data set and the second data set from the sampled-data set according to the preset algorithm, and uses the first data set and the second data set to calculate the value of the parameter included in each model and the deviation corresponding to each model. The method for calculating the value of the parameter included in each model and the deviation corresponding to each model is similar to the method used in manner a, and details are not described herein. The difference is that, in this manner, after obtaining the value of the parameter included in each model and the deviation corresponding to each model, the first device does not need to determine whether the deviation corresponding to each model is less than the preset value, but directly compares the deviations corresponding to various models, and uses a model with a smallest corresponding deviation as the first model.

For ease of understanding, the foregoing three model functions are still used as examples for explanation. In the foregoing example, it can be learned that the calculated deviation percentage of y = 2x is 6.7%, the deviation percentage of $y = p * x + q$ is 8.0%, and the deviation percentage of $y = a * x^2 + b * x + c$ is 9.5%. The deviation percentage of $y = 2x$ is lowest, and the first device directly determines $y = 2x$ as the first model, and parameter 2 is the value of the parameter included in the first model.

It should be noted that, in manner b, although the model with the smallest corresponding deviation is directly determined as the first model, if a user requires quite high accuracy, each model in the model set may not be able to well predict a trend change of true monitoring data. For example, if the user requires that the deviation percentage corresponding to the model should be less than 5.0%, but the deviation percentage of the model function y = 2x with the smallest corresponding deviation in the foregoing three model sets has reached 6.7%, this situation cannot well respond to the needs of the user. Therefore, to further improve the accuracy, in some embodiments of this application, it is also possible to first determine whether the calculated deviation corresponding to each model is within a specific preset threshold (which may be referred to as a first threshold). For example, if the first threshold is set to 9.0%, the foregoing three model functions all meet the condition, and under the condition that the deviation is less than or equal to the first threshold, the model with the smallest corresponding deviation is selected as the first model.

It should be further noted that, in the embodiment of this application, the first threshold may be that the differences between various pieces of predicted data and the actual data are first calculated and then an average value is calculated, which is less than a specific value. The first threshold may also be that ratios between various pieces of predicted data and the actual data are first calculated and then an average value is calculated, which is less than a specific value. The first threshold may also be that ratios between the differences (that is, the differences between various pieces of predicted data and the actual data) and the actual data are first calculated and then an average value is calculated, which is less than a specific value (that is, the foregoing deviation percentage). A specific representation of the first threshold is not specifically limited herein. In addition, it should be further noted that the first threshold is also set according to needs of a user. If high accuracy is required, the first threshold may be set to a smaller value. If the required accuracy is not high, the first threshold may be set to a larger value. Details are not limited herein.

303. The first device sends the identifier of the first model and the value of the parameter included in the first model to the second device.

Finally, the first device sends an identifier of the determined first model (that is, a model identifier) and the value of the parameter of the first model to the second device. If the first model exists in the second device (for example, the second device is a network device or a network management device), the second device can identify a corresponding model on the second device based on the identifier, and then substitute the value of the corresponding parameter into the model. Because both the first device and the second device have the model and the value of the parameter included in the model, the first device or the second device can predict subsequent monitoring data based on the model and the value of the parameter included in the model, so as to understand a trend status of the true monitoring data.

It should be noted that, in some embodiments of this application, if the second device is a network device, the first model may not exist on the second device (that is, the second device can support the first model, but the first model is not available on the second device), the first device can further send the first model to the second device, so that both the first device and the second device have the first model. In other words, the first device and the second device each can predict subsequent monitoring data based on the model and the value of the parameter included in the model, so as to understand a trend status of the true monitoring data.

In the foregoing embodiments of this application, because the first device and the second device exchange only the identifier of the first model and the value of the parameter included in the first model, so that the first device and the second device only need to exchange a small amount of data (much less than the amount of data in the periodic reporting method) to predict a trend status of the true monitoring data, thereby alleviating bandwidth pressure and reducing data backhaul bandwidth.

It should be noted that, in some embodiments of this application, each piece of sampled data in the second data set is used as verification data to verify each model, that is, to verify whether a deviation between the actual data and the predicted data determined based on each piece of sampled data in the second data set is within a deviation range (which may also be referred to as a second threshold). If there is a large amount of sampled data in the second data set, there may be sampled data that exceeds the second threshold. The sampled data that exceeds the second threshold is referred to as abnormal sampled data. The abnormal sampled data includes actual data and data as an independent variable. In other words, the abnormal sampled data is sampled data for which the deviation between the actual data and the predicted data obtained based on the data as an independent variable and the first model is greater than the second threshold. In addition, in addition to the abnormal sampled data that may exist in the current preset sampling period, there may be sampled data that exceeds the second threshold in a subsequent sampling period (which may be referred to as a target sampling period; a sampled-data set in the target sampling period may be referred to as a target sampled-data set). The sampled data that exceeds the second threshold and that is obtained in the subsequent sampling period is also referred to as abnormal sampled data. Regardless of the current preset sampling period or the subsequent sampling period, if there is abnormal sampled data, the first device obtains the abnormal sampled data. Specifically, if the first device is a network device and the second device is a network management device, a method in which the first device obtains abnormal sampled data may be that the second device calculates the abnormal sampled data based on the collected sampled data and the second threshold, and then the first device reports the abnormal sampled data to the second device; if the first device is a network management device and the second device is a network device, the method in which the first device obtains abnormal sampled data may be that the first device directly determines the abnormal sampled data based on the sampled data reported by the second device and the second threshold. How the first device obtains the abnormal sampled data is not specifically limited herein.

It should be further noted that, in some embodiments of this application, after obtaining the abnormal sampled data, the first device uses the actual data included in the abnormal sampled data to replace the predicted data that is determined based on the data as an independent variable in the first model and the first model. For ease of understanding, the examples of the foregoing three model functions are still used for description. It is assumed that the first device determines $y = 2x$ as the first model according to the foregoing method in the foregoing embodiment of this application. If sampled data (6, 15) is obtained in a subsequent sampling period, where 6 is the independent variable, and the predicted data obtained based on the model function is 12, then the deviation percentage is (15-12)/15=20%. Assuming that the second threshold is set to 16%, the sampled data (6, 15) is abnormal sampled data. The first device replaces the predicted data with the actual data in the sampled data, that is, uses the abnormal sampled data (6, 15) to replace the predicted data (6, 12).

It should be further noted that, in the embodiment of this application, the second threshold may be that the differences between various pieces of predicted data and the actual data are first calculated and then an average value is calculated, which is greater than a specific value. The second threshold may also be that ratios between various pieces of predicted data and the actual data are first calculated and then an average value is calculated, which is greater than a specific value. The second threshold may also be that ratios between the differences (that is, the differences between various pieces of predicted data and the actual data) and the actual data are first calculated and then an average value is calculated, which is greater than a specific value (that is, the foregoing deviation percentage). A specific representation of the second threshold is not specifically limited herein. In addition, it should be further noted that the second threshold is also set according to needs of a user. If high accuracy is required, the second threshold may be set to a smaller value. If the required accuracy is not high, the second threshold may be set to a larger value. Details are not limited herein.

In the foregoing embodiments of this application, after the first model and the value of the parameter included in the first model are determined, as long as there is sampled data that exceeds the deviation range corresponding to the first model in any sampling period (that is, sampled data exceeding the second threshold), the first device obtains the abnormal sampled data (that is, the actual data that is truly monitored), and uses the abnormal sampled data to replace the predicted data that is determined in the first model based on the data as an independent variable and the first model, so as to reduce impact of some inaccurate predicted data on the first model, and correct the first model.

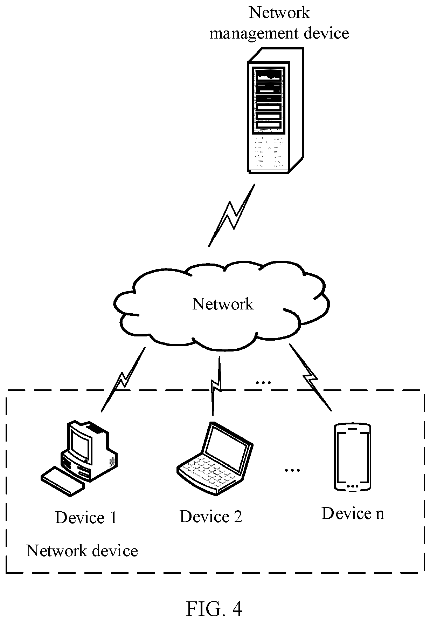

It should be noted that, in the foregoing embodiments of this application, this data reporting method can be used in various systems. When the applied systems are different, the first device and the second device may be different types of terminal devices. The following provides detailed description by using an example in which the data reporting method is used in a network monitoring system. It should be noted that an architecture of the network monitoring system in the embodiment of this application may be the architecture shown in FIG. 1 or FIG. 2, that is, a network management device includes a controller, a collector, and an analyzer; the architecture of the network monitoring system may also be shown in FIG. 4, that is, a network device does not distinguish between specific modules (that is, there are no specific functional modules such as a controller, a collector, and an analyzer), and the foregoing data reporting method is implemented based on interaction between one or more physical units in the network management device in FIG. 4 and the network device. For ease of explanation, all architectures of the network monitoring system used in the following are the architecture shown in FIG. 1 or FIG. 2 (that is, the network management device includes a controller, a collector, and an analyzer). The following describes a specific implementation for applying the data reporting method in the embodiment of this application to the network monitoring system.

1. Specific implementation for the data reporting method when the first device is a network device and the second device is a network management device.

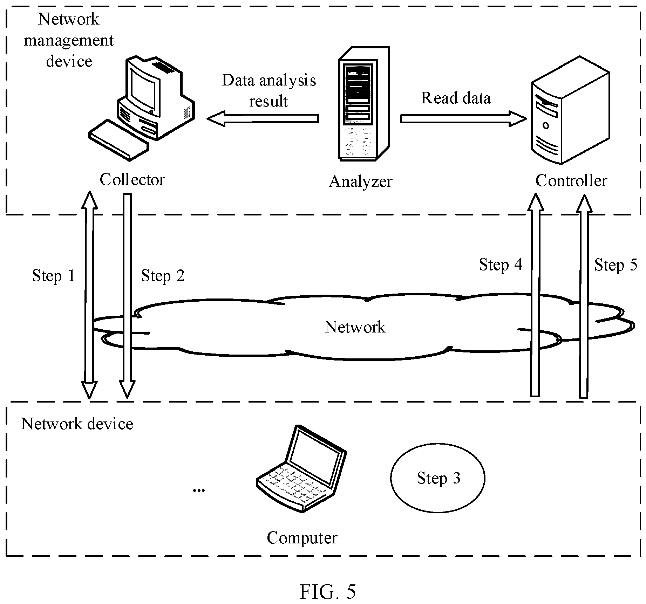

In the embodiment of this application, there may be one or more network devices. For ease of explanation, in the network monitoring system in FIG. 5, one network device (that is, a computer in FIG. 5) is used as an example to describe a specific process of the entire data reporting method. For other network devices in the system, the data reporting methods are similar, and details are not described herein. In the embodiment of this application, the data reporting method includes five steps, as shown in FIG. 5.

Step 1: A stage at which a network management device and a network device perform model negotiation.

According to the technical solution in this application, first, the network device and the network management device synchronize one or more models supported by both parties. A specific synchronization method may be to define an rpc (which may be referred to as get-model-info) for obtaining model information on the network management device side. When the network device goes online for the first time or the network device is reconnected after disconnection, the controller in the network management device can send the rpc in a message to obtain information (such as a type of the supported model, a quantity of models, a model identifier, and a specific expression of the model) about the model supported by the network device. The rpc may be defined as follows:

```
+--x get-model-info

  +--ro output

  |   +--ro model-set          [name]

  |      +--ro name            string

  |      +--ro info            anydata
```

Here, model-set represents a list node, where name is used to indicate a specific model (name is the identifier of the model described above); info represents the anydata type, used to carry the model and a parameter included in the model. When there is a model on the network device, the controller of the network management device can obtain, through the rpc, information about all models supported by the network device. Then, the controller determines the model set (including one or more models supported by both the network device and the network management device) based on the model supported by the network device and the model supported by the network management device.

When there is no model on the network device, the controller can set a model through the following rpc, which is set-model-info. The rpc is defined as follows:

```
+--x set-model-info

  +--w input

    |   +--rw model-set          [name]

    |     +--rw name              string

    |     +--rw info              anydata
```

Similarly, model-set represents a list node, where name is used to indicate a specific model (name is the identifier of the model described above); info represents the anydata type, used to carry the model and a parameter included in the model. The controller can set one or more models through the foregoing set-model-info, and the set one or more models constitute the model set. The model set includes one or more models supported by both the network device and the network management device.

Step 2: A stage at which the network management device sends a configuration.

In the embodiment of this application, a telemetry.yang module is customized. Based on a common model set, the telemetry.yang module is used to carry a configuration parameter sent by the network device (for example, a controller of the network device). The model-prediction container node is used to contain configuration information; enabled takes true or false as a parameter to represent whether to enable a model prediction-based reporting method, that is, whether the network device enables a function of determining the first model from the model set. If the statement is not defined, a default value is false, and deviation is empty in this case; when enabled is set to true, it indicates that the network device enables the model prediction function (to be specific, the network device enables the function of determining the first model from the model set, and this determining process may be referred to as model prediction). In this case, deviation cannot be empty. In the deviation container, percent defines a deviation percentage between current actual data and predicted data; value defines a deviation value between the current actual data and the predicted data; period represents that the network device reports the first model determined from the model set to the network management device; status-exception represents whether the controller enables an abnormal sampled data reporting mode, and a default value is true, indicating that the abnormal sampled data reporting mode is enabled. In the model-training container, learning time represents a start learning time of the network device, that is, a preset sampling period, during which the network device collects sampled data; sliding window represents a size of a sliding window of the network device, where sampled data is data collected based on this dynamic window; sliding distance represents a sliding step size, indicating that the foregoing sliding window of the network device moves based on a preset period. The telemetry.yang module is defined as follows:

```
module: telemetry

  +--rw telemetry-system

    +--rw model-prediction

  |   +--rw enabled                 boolean

  |   +--rw deviation

      |   +--rw percent            uint64

      |   +--rw value              unit64

  |   +--rw period                unit64

  |   +--rw status-exception       boolean

  |   +--rw model-training

  |     |   +--rw learning time     uint64

  |     |   +--rw sliding window    unit64

  |     |   +--rw sliding distance  unit64
```

Similarly, for each network device served by the same network monitoring system, if each network device has obtained each model in the model set through the foregoing step 1, each network device can import the foregoing telemetry.yang module into its own .yang module, set enabled to true, and fill in detailed configuration parameters in the foregoing manner according to needs of the network device.

Step 3: A stage at which the network device determines the first model from the model set.

After obtaining each configuration parameter through the foregoing telemetry.yang module, the network device determines the first model from the model set based on the configuration parameter. The process of determining the first model is divided into two stages: (1) model training stage; (2) model verification stage. The following separately describes the two stages.

(1) Model training stage

The network device performs model initialization based on the known model set and the information about the model-prediction node sent in the form of a configuration. Then, the network device side divides the sampled data in the sampled-data set into predicted data and verification data according to a preset ratio (such as 7:3) and based on the sampled-data set within a time corresponding to the learning time. The model is trained based on the predicted data to obtain the value of the parameter included in the model. Similarly, the foregoing training is performed on each model in the model set to obtain the value of the parameter included in each model. The sliding window slides forward in sequence based on the sliding distance (sliding distance) to reach the length of the sliding window, and finally stabilizes to the size of the sliding window.

For example, using a traffic monitoring scenario as an example, for a network device that already has a model set, the network device obtains the following configuration parameter from the controller:

```
<telemetry-system>
     <model-prediction>
       <enabled>true</enabled>
       <deviation>
          <percent>20</percent>
          <value>10</value>
       <deviation>
    <period>60</period>
```

```
<status-exception>true</status-exception>
<model-training>
    <learning time>600</leaming time>
    <sliding window>86400</sliding window>
    <sliding distance>86400</sliding distance>
</model-training>
   </model-prediction>
</telemetry-system>
```

When enabled is set to true, it indicates that the network device enables the model prediction function (to be specific, the network device enables the function of determining the first model from the model set, and this determining process may be referred to as model prediction). In deviation, 20 of percent represents a percentage of an average value of deviations between the predicted data and the actual data collected by the network device; when value is set to 10, it indicates that a difference between predicted data obtained at the current moment and the actual data is 10 megabytes; when period is set to 60, it indicates that the network device periodically reports related data every 60s (for example, periodically reports model information, and periodically reports abnormal sampled data); when status-exception is set to true, it indicates that the controller supports the network device in reporting abnormal data. In the model-training node, when learning time is set to 600, it indicates the model learning time of the network device in the first 600s (that is, the sampled-data set is obtained and each model is trained in the period of 600s); sliding window (sliding window) indicates a size of the sliding window maintained by the network device, where 86400s, that is, 24h represents one day; sliding distance (sliding distance) represents that the sliding window moves every 5s.

The following uses traffic monitoring as an example to describe how to determine the value of the parameter included in the model. The network device obtains the model set sent by the controller at the model negotiation stage. It is assumed that the model set includes an auto-regressive moving average model (Auto-Regressive Moving Average Model, ARMA) and support vector regression (Support Vector Regression, SVR). For example, the value of the parameter included in ARMA is determined. It is known that an expression of the ARMA model function is $y_t =$

$$\sum_{k=1}^{p} \varphi_k y_{t-k} + e_t + \sum_{k=1}^{q} \theta_k e_{t-k}$$, where an operation order d in the expression is not reflected in the expression. The network device divides a plurality of pieces of sampled data collected within the learning time into predicted data and verification data according to a ratio of 7:3. The network device uses the predicted data and the verification data to perform the foregoing model training, so as to obtain values of parameters (p, q, d) included in the model in the ARMA model function expression. Similarly, the SVR also uses the foregoing predicted data and verification data to obtain the values of the parameters included in the SVR, and details are not described herein.

(2) Model verification stage

At the foregoing model training stage, the value of the parameter included in each model in the model set on the network device is determined. The following uses the verification data in the sampled-data set to verify each model, so as to determine whether the corresponding model can predict a trend of change in subsequent true monitoring data. When an error between the true monitoring data and the predicted data obtained through the model in the model set is smallest, it indicates that the corresponding model can well fit the true value, and the model with the smallest error is determined as the first model. How to use the verification data to verify each model has been described in detail in the embodiment corresponding to FIG. 3, and details are not described herein.

Step 4: A reporting stage.

After determining the first model based on step 3 described above, the network device reports the identifier of the first model to the network management device. Because the model set exists on both the network device and the network management device, the network management device can identify, after obtaining the identifier of the first model sent by the network device, the corresponding model as the first model based on the identifier. Then, the network management device can directly use the first model and the value of the parameter included in the first model to predict subsequent true monitoring data on the network device, so as to obtain a trend of change in the true monitoring data.

It should be noted that, in some specific implementations, the network device can also perform reporting based on the reporting period parameter period configured and sent by the controller. To be specific, in each period, the network device collects data within the corresponding period as a sampled-data set, and then periodically determines the first model from the model set based on the process of step 3 described above. Because the first model determined in each period is determined based on the sampled data of the current period, the first model determined in the current period (for example, the first model determined in the current period is model A) and the first model determined in the previous period (for example, the first model determined in the previous period is model B) may be different, but the deviation corresponding to the first model determined in each period is smallest. Therefore, the method for periodically determining the first model and reporting the identifier of the first model is more accurate. Specifically, the network device calculates the predicted data $F(x)_{prediction}$ based on the first model, and the current true data collected in real time is $F(x)$. When $|F(x) - F(x)_{prediction}| \div F(x) \leq percent$ or $|F(x) - F(x)_{prediction}| \leq value$, it indicates that the predicted data obtained through this model can well describe the value of the true monitoring data. In this case, the network device only needs to periodically report the identifier of the model (that is, the name in the foregoing rpc) and the value of the parameter included in the model. The network management device (such as the collector of the network management device) determines the corresponding first model based on the received model identifier, and predicts the monitoring data in this period based on the first model and the value of the parameter included in the first model, so as to obtain the predicted data in this period. In this case, a model-info node needs to be added to the telemetry.yang module, where name represents the name of the first model, and info represents the value of the parameter included in the first model. The periodically reported telemetry.yang module is defined as follows:

```
module: telemetry

    +--rw telemetry-system

        +--rw model-info




            |    +--rw name            string

            |    +--rw info            anydata
```

Step 5: An exception reporting stage.

If the sampled data obtained by the network device in any period meets the conditions $|F(x) - F(x)_{prediction}| \div F(x) > percent$ and $|F(x) - F(x)_{prediction}| > value$, the sampled data that meets the conditions is determined as abnormal sampled data, indicating that the predicted data obtained through the reported first model cannot well describe the value of the true monitoring data. In this case, the network device reports the abnormal sampled data to the network management device (for example, to the collector of the network management device), and the collector uses the received abnormal sampled data to replace the corresponding independent variable in the first model and the predicted data obtained based on the independent variable (that is, the first model is corrected). In this case, an exception-info node needs to be added to the telemetry.yang module, where name represents the name of the first model; info represents the value of the parameter included in the first model; exception-value represents a true value of the currently obtained abnormal sampled data. To be specific, the telemetry.yang module reported upon an exception is defined as follows:

```
module: telemetry

    +--rw telemetry-system

        +--rw exception-info

            |    +--ro name            string

            |    +--ro info            anydata

        |    +--ro exception-value        anydata
```

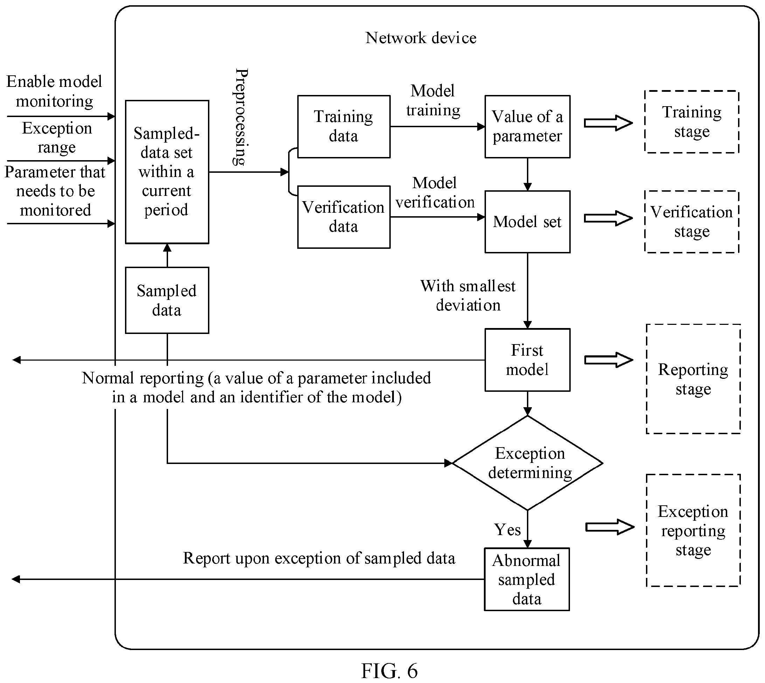

It can be learned from steps 1 to 5 that, after the network device and the network management device complete the model negotiation, the network device obtains the model set supported by both parties. Then, the network device needs to enter the training stage and the verification stage for each model in the model set, and finally obtains the best model (that is, the first model). Then, the network device enters the reporting stage and the exception reporting stage. For a detailed overall process on the network device side, refer to FIG. 6. Details are not described herein.

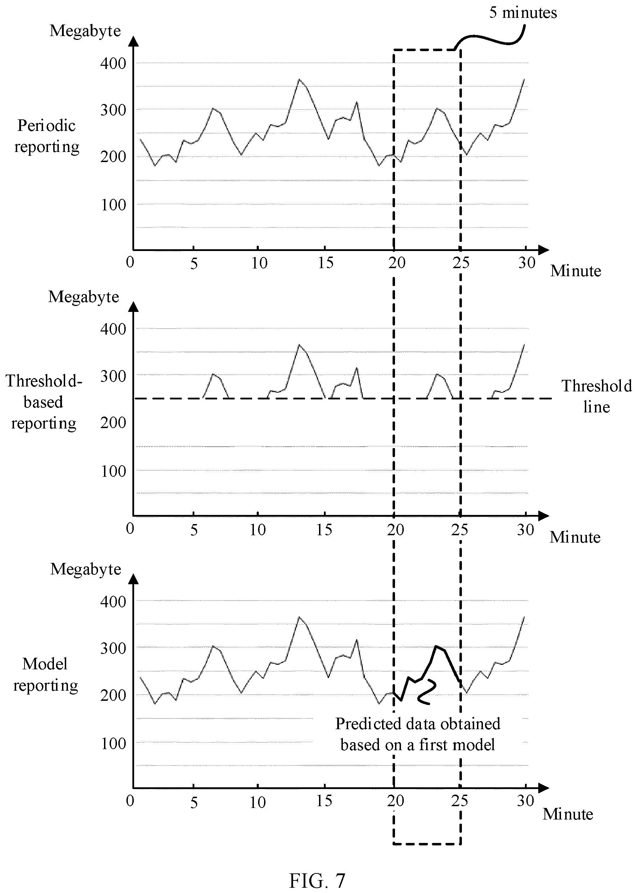

To better understand the advantages of the technical solution in this application, as shown in FIG. 7, the technical solution in this application is compared with the existing periodic reporting and threshold-based reporting for analysis. The reporting period in the network traffic monitoring system is 1s. For example, the reporting period in this solution is five minutes, and the data collection frequency is one piece per second. It can be seen from FIG. 7 that the periodic reporting method requires full reporting of all data collected within five minutes, that is, 300 pieces of sampled data need to be reported; the threshold-based reporting method only requires reporting of approximately 100 pieces of data that exceed the threshold (that is, beyond the dashed line); and the model reporting method in this application requires reporting of only the identifier of the determined first model and the value (that is, one piece of data) of the parameter included in the model, thereby greatly reducing an amount of reported data, significantly reducing a size of the reported data, alleviating pressure of data reporting, and expanding a reporting period.

In summary, when the first device is a network device and the second device is a network management device, the network device and the network management device first need to synchronize the model set, that is, to ensure that the network device and the network management device have one or more identical models. Then, the network device determines the first model from the model set, and reports the identifier of the first model and the value of the parameter included in the first model to the network management device. The network management device identifies the first model based on the identifier, and further predicts, through the first model, the trend of change in the true monitoring data on the network device. When the network device obtains abnormal sampled data, the network device reports the obtained abnormal sampled data to the network management device, so that the network management device uses the abnormal sampled data to replace the predicted data obtained through the first model, making the network monitoring method more accurate and flexible.

2. Specific implementation for the data reporting method when the first device is a network management device and the second device is a network device.

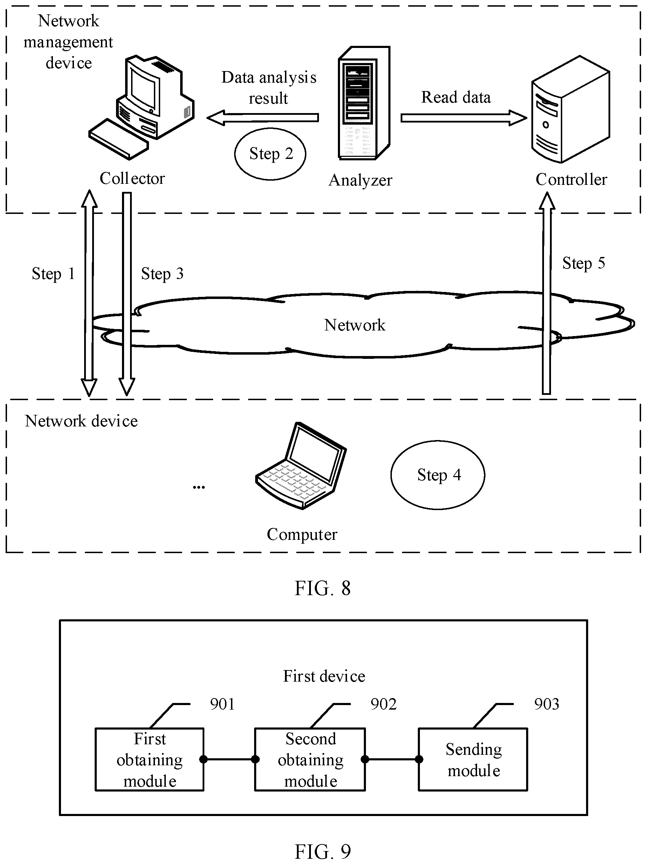

Similarly, in the embodiment of this application, there may be one or more network devices. For ease of explanation, in the network monitoring system in FIG. 8, one network device (that is, a computer in FIG. 8) is used as an example to describe a specific process of the entire data reporting method. When the first device serves as the network management device, the step of determining the first model from the model set is performed by the network management device. In the embodiment of this application, the data reporting method also includes five steps, as shown in FIG. 8.

Step 1: A stage at which a network management device and a network device perform model negotiation.

According to the technical solution in this application, because the step of determining the first model from the model set is performed by the network management device, the network management device side can also execute an rpc (which may be referred to as get-model-info) for obtaining model information. When the network device goes online for the first time or the network device is reconnected after disconnection, the controller in the network management device can send the rpc in a message to obtain information (such as a type of the supported model, a quantity of models, a model identifier, and a specific expression of the model) about the model supported by the network device. The definition of the rpc is similar to that in the foregoing description. Details are not described herein.

After obtaining the information about the model supported by the network device, the network management device further determines a model set based on a candidate model set supported by the network management device and a candidate model set supported by the network device. The model set includes the models supported by both parties. Unlike step 1 described above, according to the technical solution in this application, the network management device only needs to store the model set locally, without a need to send the model set to the network device.

Step 2: A stage at which the network management device determines the first model from the model set.

This step is similar to step 3 described above, and the only difference is that after obtaining the sampled-data set in the preset period, the network device directly reports the sampled-data set to the network management device, and the network management device trains and verifies each model in the model set based on the sampled-data set, and finally determines the first model and the value of the parameter included in the first model from the model set. The step of training and verification is similar to step 3 described above, and details are not described herein.

Step 3: A stage at which the network management device sends a configuration.

In the embodiment of this application, a control-model container is added to the telemetry.yang module in step 2 described above to carry a configuration parameter sent by the network device (for example, a controller of the network device). The configuration parameter includes the value of the parameter included in the first model and the identifier of the first model, where name represents a model selected from the model set; enabled, deviation, period, and status-exception have the same meanings as those in step 2 described above, and details are not described herein.

```
module: telemetry

  +--rw telemetry-system

    +--rw data-period

    |   +--rw data                    anydata

    |   +--rw deviation

    |       +--rw percent             uint64

    |       +--rw value               unit64

    |   +--rw period                  unit64

    |   +--rw status-exception        boolean
```

It should be noted that, in the embodiment of this application, because the network device does not initially obtain the model set that is determined by the network management device, when the network device does not have the first model (that is, the network device cannot find the corresponding first model based on the name sent by the network management device, indicating that the network device does not have the first model), the network management device further needs to send the first model to the network device after sending the configuration. If the network device identifies the corresponding first model based on the name sent by the network management device, it indicates that the network device has the first model, and the network management device does not need to send the first model to the network device in this case.

Step 4: A stage at which the network device performs calculation and comparison.

After determining the first model, the network device calculates and compares, based on the obtained configuration parameter, the sampled data $F(x)$ obtained in any period and the preset data $F(x)_{prediction}$ calculated through the first model. When $|F(x) - F(x)_{prediction}| \div F(x) \leq percent$ or $|F(x) - F(x)_{prediction}| \leq value$, it indicates that the predicted data obtained through the first model can well describe the value of the true monitoring data. In this case, the network device does not need to report data to the network management device.

Step 5: An exception reporting stage.

If the sampled data obtained by the network device in any period meets the conditions $|F(x) - F(x)_{prediction}| \div F(x) > percent$ and $|F(x) - F(x)_{prediction}| > value,$ the sampled data that meets the conditions is determined as abnormal sampled data, indicating that the predicted data obtained through the reported first model cannot well describe the value of the true monitoring data. In this case, the network device reports the abnormal sampled data to the network management device (for example, to the collector of the network management device), and the collector uses the received abnormal sampled data to replace the corresponding independent variable in the first model and the predicted data obtained based on the independent variable (that is, the first model is corrected). In the embodiment of this application, the method in which the network device reports abnormal sampled data is similar to the telemetry.yang module reported upon an exception in step 5 described above, where name and info are empty, and only exception-value has data (that is, the abnormal sampled data). The telemetry.yang module reported upon an exception is defined as follows:

```
module: telemetry

+--rw telemetry-system

+--rw exception-info

|   +--ro name              string

|   +--ro info              anydata

|  +--ro exception-value    anydata
```

In summary, when the first device is a network management device and the second device is a network device, it only needs to ensure that the model set supported by both the network management device and the network device exists on the network management device. After the network management device obtains the sampled-data set reported by the network device, the network management device determines the first model and the value of the parameter included in the first model from the model set based on the sampled-data set, so that the network management device can predict the trend of change in the true monitoring data on the network device through the first model. In addition, the network management device further sends the identifier of the first model and the value of the parameter to the network device in the form of configuration parameters (if the first model does not exist on the network device, the network management device further sends the first model to the network device), so that the network device determines whether there is abnormal sampled data through the first model. When the network device obtains abnormal sampled data, the network device reports the obtained abnormal sampled data to the network management device, so that the network management device uses the abnormal sampled data to replace the predicted data obtained through the first model, making the network monitoring method more accurate and flexible.

In the embodiments of this application, the first device (such as the network device and the network management device) may be divided into functional modules based on the foregoing examples of the data reporting method. For example, functional modules may be obtained through division based on corresponding functions, or two or more functions may be integrated into one processing module. The integrated module may be implemented in a form of hardware, or may be implemented in a form of a software functional module. It should be noted that, in this embodiment of this application, module division is merely an example, and is merely a logical function division. In actual implementation, another division manner may be used.

For example, FIG. 9 is a schematic diagram of a first device. The first device provided in an embodiment of this application includes:

a first obtaining module 901, configured to obtain a sampled-data set within a preset sampling period, where the sampled-data set includes a plurality of pieces of sampled data;
a second obtaining module 902, configured to obtain a first model and a value of a parameter included in the first model from a model set based on the sampled-data set, where the model set includes one or more models supported by both the first device and a second device; and
a sending module 903, configured to send an identifier of the first model and the value of the parameter included in the first model to the second device.

The second obtaining module 902 is specifically configured to:

obtain a first data set and a second data set from the sampled-data set according to a preset algorithm, where the first data set includes at least one of the plurality of pieces of sampled data, and the second data set includes at least one of the plurality of pieces of sampled data;
obtain a value of a parameter included in a second model based on the first data set;
obtain a deviation corresponding to the second model based on the second data set and the value of the parameter included in the second model, where the deviation corresponding to the second model is the sum of differences between actual data and predicted data determined based on the second model, the value of the parameter included in the second model, and the sampled data included in the second data set; and
when the deviation corresponding to the second model is less than a preset value, use the second model as the first model, where the value of the parameter included in the first model is a value of a parameter included in the second model.

In some embodiments of this application, the second obtaining module 902 is specifically configured to:

obtain a first data set and a second data set from the sampled-data set according to a preset algorithm, where the first data set includes at least one of the plurality of pieces of sampled data, and the second data set includes at least one of the plurality of pieces of sampled data;
obtain a value of a parameter included in a second model and a value of a parameter included in a third model based on the first data set;
obtain a deviation corresponding to the second model based on the second data set and the value of the parameter included in the second model, where the deviation corresponding to the second model is the sum of differences between actual data and predicted data determined based on the second model, the value of the parameter included in the second model, and the sampled data included in the second data set;
obtain a deviation corresponding to the third model based on the second data set and the value of the parameter included in the third model, where the deviation corresponding to the third model is the sum of differences between actual data and predicted data determined based on the third model, the value of the parameter included in the third model, and the sampled data included in the second data set; and
determine the first model based on the deviation corresponding to the second model and the deviation corresponding to the third model, where the first model is a model corresponding to a smaller deviation in the second model and the third model, and the value of the parameter included in the first model is a value of a parameter included in the model corresponding to the smaller deviation in the second model and the third model.

In some embodiments of this application, the deviation corresponding to the second model is less than or equal to a first threshold, and the deviation corresponding to the third model is less than or equal to the first threshold.
In some embodiments of this application, if the first device is a network management device and the second device is a network device, the sending module 903 is further configured to:
send the first model to the second device.
In some embodiments of this application, the second obtaining module 902 is further configured to:
obtain abnormal sampled data in the sampled-data set, where the abnormal sampled data includes actual data and data as an independent variable; the abnormal sampled data is sampled data for which a deviation between the actual data and the predicted data obtained based on the data as an independent variable and the first model is greater than a second threshold.
In some embodiments of this application, the second obtaining module 902 is further specifically configured to:

receive the abnormal sampled data sent by the second device; or
obtain the abnormal sampled data through calculation based on the second data set and the second threshold.

In some embodiments of this application, if the first device is a network management device, the second obtaining module 902 is further specifically configured to:
use the actual data included in the abnormal sampled data to replace the predicted data that is determined based on the data as an independent variable in the first model and the first model.
In some embodiments of this application, if the first device is a network device, the second obtaining module 902 is further configured to:
send a first candidate model set to the second device, and obtain a fourth model and an identifier of the fourth model sent by the second device, where the first candidate model set includes a model supported by the first device; the fourth model and the identifier of the fourth model are determined by the second device based on a second candidate model set and the first candidate model set; the second candidate model set includes a model supported by the second device; and the fourth model is a model in the model set that needs to be synchronized to the first device.
In some embodiments of this application, if the first device is a network management device, the second obtaining module 902 is further configured to:

obtain a first candidate model set sent by the second device, where the first candidate model set includes a model supported by the second device; and
obtain a fifth model and an identifier of the fifth model based on the second candidate model set and the first candidate model set, where the second candidate model set includes the model supported by the first device, and the fifth model is any model in the model set.

The specific function and structure of the first device in the embodiment corresponding to FIG. 9 are used to implement the foregoing steps of processing by the first device in FIG. 3 to FIG. 8, and details are not described herein.

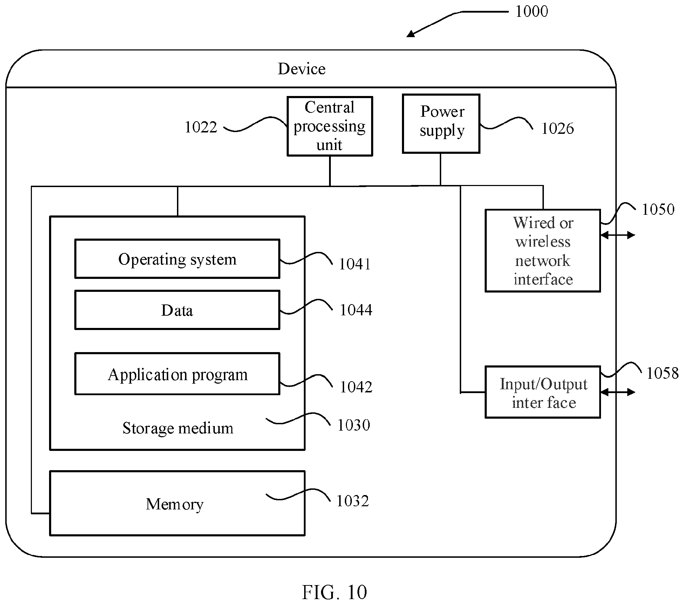

FIG. 10 is a schematic diagram of a related device (which may be a first device or a second device) according to an embodiment of this application. For ease of description, only parts related to the embodiment of this application are illustrated. For specific technical details that are not disclosed, refer to the method part in the embodiments of this application. The device 1000 may vary greatly due to different configurations or performance, and may include one or more central processing units (central processing units, CPU) 1022 (for example, one or more processors), a memory 1032, and one or more storage medium 1030 (for example, one or more mass storage devices) that store an application program 1042 or data 1044. The memory 1032 and the storage medium 1030 may be transitory or persistent storage. The program stored in the storage medium 1030 may include one or more modules (not shown in the figure), and each module may include a series of instruction operations for a server. For example, if the device 1000 is a network management device, the corresponding instruction operations may be: obtaining a sampled-data set within a preset sampling period, where the sampled-data set is sent by a second device (for example, a network device) to the network management device; then obtaining a first model and a value of a parameter included in the first model from a model set based on the sampled-data set; and finally sending an identifier of the first model and the value of the parameter included in the first model to the second device (for example, the network device). Similarly, if the device 1000 is a network device, the corresponding operation instructions may be: collecting a sampled-data set within a preset sampling period, and determining a first model and a value of a parameter included in the first model from a model set based on the sampled-data set; and then sending an identifier of the first model and the value of the parameter included in the first model to the second device (for example, the network management device).

Further, the central processing unit 1022 may be configured to communicate with the storage medium 1030, to perform, on the device 1000, the series of instruction operations in the storage medium 1030.

The device 1000 may further include one or more power supplies 1026, one or more wired or wireless network interfaces 1050, one or more input/output interfaces 1058, and/or one or more operating systems 1041, for example, Windows ServerTM, Mac OS XTM, UnixTM, LinuxTM, and FreeBSDTM.

If the device 1000 is the first device, the steps performed by the first device in the embodiment corresponding to FIG. 3 to FIG. 8 can be implemented based on the structure shown in FIG. 10. If the device 1000 is the second device, the steps performed by the second device in the embodiment corresponding to FIG. 3 to FIG. 8 can also be implemented based on the structure shown in FIG. 10. Details are not limited herein.

All or some of the foregoing embodiments may be implemented by using software, hardware, firmware, or any combination thereof. When the software is used to implement the embodiments, the embodiments may be implemented all or partially in a form of a computer program product.

The computer program product includes one or more computer instructions. When the computer program instructions are loaded and executed on a computer, the procedures or the functions according to the embodiments of this application are all or partially generated. The computer may be a general-purpose computer, a special-purpose computer, a computer network, or another programmable apparatus. The computer instructions may be stored in a computer-readable storage medium or may be transmitted from one computer-readable storage medium to another computer-readable storage medium. The computer-readable storage medium may be any usable medium accessible by the computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive), or the like.

Claims

1.   A data reporting method, comprising:

obtaining (301), by a first device, a sampled-data set within a preset sampling period, wherein the sampled-data set comprises a plurality of pieces of sampled data;
obtaining (302), by the first device, a first model and a value of a parameter comprised in the first model from a model set based on the sampled-data set, wherein the model set comprises one or more models supported by both the first device and a second device; and
sending (303), by the first device, an identifier of the first model and the value of the parameter comprised in the first model to the second device,
wherein the obtaining (302), by the first device, a first model and a value of a parameter comprised in the first model from a model set based on the sampled-data set comprises:

obtaining, by the first device, a first data set and a second data set from the sampled-data set according to a preset algorithm, wherein the first data set comprises at least one of the plurality of pieces of sampled data, and the second data set comprises at least one of the plurality of pieces of sampled data;
obtaining, by the first device, a value of a parameter comprised in a second model in the model set based on the first data set, wherein obtaining, by the first device, a value of a parameter comprised in the second model based on the first data set comprises: training the second model using the sampled data comprised in the first data set to obtain the value of the parameter comprised in the second model;

obtaining, by the first device, a deviation corresponding to the second model based on the second data set and the value of the parameter comprised in the second model, wherein the deviation corresponding to the second model is a sum of differences between actual data and predicted data determined based on the second model, wherein the predicted data determined based on the second model is determined by inputting the sampled data comprised in the second data set into the second model; and

when the deviation corresponding to the second model is less than a preset value, using, by the first device, the second model as the first model, wherein the value of the parameter comprised in the first model is the value of the parameter comprised in the second model.

2. The method according to claim 1, wherein if the first device is a network management device and the second device is a network device, the method further comprises:
sending, by the first device, the first model to the second device

3. The method according to any one of claims 1 to 2, wherein the method further comprises:
obtaining, by the first device, abnormal sampled data in the sampled-data set, wherein the abnormal sampled data comprises actual data and data as an independent variable in the first model; the abnormal sampled data is sampled data for which a deviation between the actual data and predicted data is greater than a second threshold, wherein the predicted data is obtained based on the data as the independent variable and the first model.

4. The method according to claim 3, wherein the obtaining, by the first device, abnormal sampled data in the sampled-data set comprises:

receiving, by the first device, the abnormal sampled data sent by the second device; or
obtaining, by the first device, the abnormal sampled data through calculation based on the second data set and the second threshold

5. The method according to claim 3 or 4, wherein if the first device is a network management device, the method further comprises:
using, by the first device, the actual data comprised in the abnormal sampled data to replace the predicted data that is determined based on the data as the independent variable in the first model and the first model.

6. The method according to claim 1 or claim 3 or 4, wherein if the first device is a network device, the method further comprises:

sending, by the first device, a first candidate model set to the second device, wherein the first candidate model set comprises a model supported by the first device; and
obtaining, by the first device, a fourth model and an identifier of the fourth model sent by the second device, wherein the fourth model and the identifier of the fourth model are determined by the second device based on a second candidate model set and the first candidate model set; the second candidate model set comprises a model supported by the second device; and the fourth model is a model in the model set that needs to be synchronized to the first device

7. The method according to any one of claims 1 to 5, wherein if the first device is a network management device, the method further comprises:

obtaining, by the first device, a first candidate model set sent by the second device, wherein the first candidate model set comprises a model supported by the second device; and
obtaining, by the first device, a fifth model and an identifier of the fifth model based on a second candidate model set and the first candidate model set, wherein the second candidate model set comprises a model supported by the first device, and the fifth model is any model in the model set.

8. A device, wherein the device is used as a first device and comprises:

a first obtaining module (901), configured to obtain a sampled-data set within a preset sampling period, wherein the sampled-data set comprises a plurality of pieces of sampled data;

a second obtaining module (902), configured to obtain a first model and a value of a parameter comprised in the first model from a model set based on the sampled-data set, wherein the model set comprises one or more models supported by both the first device and a second device; and

a sending module (903), configured to send an identifier of the first model and the value of the parameter comprised in the first model to the second device,

wherein the second obtaining module (902) is specifically configured to:

obtain a first data set and a second data set from the sampled-data set according to a preset algorithm, wherein the first data set comprises at least one of the plurality of pieces of sampled data, and the second data set comprises at least one of the plurality of pieces of sampled data;

obtain a value of a parameter comprised in a second model in the model set based on the first data set, wherein obtaining of the value of the parameter comprised in the second model based on the first data set comprises: training the second model using the sampled data comprised in the first data set to obtain the value of the parameter comprised in the second model;

obtain a deviation corresponding to the second model based on the second data set and the value of the parameter comprised in the second model, wherein the deviation corresponding to the second model is a sum of differences between actual data and predicted data determined based on the second model, wherein the predicted data determined based on the second model is determined by inputting the sampled data comprised in the second data set into the second model; and

when the deviation corresponding to the second model is less than a preset value, use the second model as the first model, wherein the value of the parameter comprised in the first model is the value of the parameter comprised in the second model.

9. The device according to claim 8, wherein if the device is a network management device and the second device is a network device, the sending module is further configured to:
send the first model to the second device

10. The device according to any one of claims 8 to 9, wherein the second obtaining module (902) is further configured to:
obtain abnormal sampled data in the sampled-data set, wherein the abnormal sampled data comprises actual data and data as an independent variable in the first model; the abnormal sampled data is sampled data for which a deviation between the actual data and predicted data is greater than a second threshold, wherein the predicted data is obtained based on the data as the independent variable and the first model.

11. The device according to claim 10, wherein the second obtaining module (902) is specifically configured to:

receive the abnormal sampled data sent by the second device; or
obtain the abnormal sampled data through calculation based on the second data set and the second threshold

12. The device according to claim 10 or 11, wherein if the device is a network management device, the second obtaining module (902) is further specifically configured to:
use the actual data comprised in the abnormal sampled data to replace the predicted data that is determined based on the data as the independent variable in the first model and the first model.

13. The device according to claim 8 or claim 10 or 11, wherein if the first device is a network device, the second obtaining module (902) is further configured to:
send a first candidate model set to the second device, and obtain a fourth model and an identifier of the fourth model sent by the second device, wherein the first candidate model set comprises a model supported by the first device; the fourth model and the identifier of the fourth model are determined by the second device based on a second candidate model set and the first candidate model set; the second candidate model set comprises a model supported by the second device; and the fourth model is a model in the model set that needs to be synchronized to the first device

14. The device according to any one of claims 8 to 12, wherein if the first device is a network management device, the second obtaining module (902) is further configured to:

obtain a first candidate model set sent by the second device, wherein the first candidate model set comprises a model supported by the second device; and
obtain a fifth model and an identifier of the fifth model based on a second candidate model set and the first candidate model set, wherein the second candidate model set comprises a model supported by the first device, and the fifth model is any model in the model set.

**Patentansprüche**

1. Datenmeldeverfahren, das Folgendes umfasst:

   Erhalten (301), durch eine erste Vorrichtung, eines Abtastdatensatzes innerhalb einer voreingestellten Abtastperiode, wobei der Abtastdatensatz eine Vielzahl von Abtastdatenstücken umfasst;
   Erhalten (302), durch die erste Vorrichtung, eines ersten Modells und eines Wertes eines Parameters, der in dem ersten Modell enthalten ist, aus einem Modellsatz, der auf dem Abtastdatensatz basiert, wobei der Modellsatz ein oder mehrere Modelle umfasst, die sowohl von der ersten Vorrichtung als auch von einer zweiten Vorrichtung unterstützt werden; und
   Senden (303), durch die erste Vorrichtung, einer Kennung des ersten Modells und des Wertes des Parameters, der in dem ersten Modell enthalten ist, an die zweite Vorrichtung,
   wobei das Erhalten (302), durch die erste Vorrichtung, eines ersten Modells und eines Wertes eines Parameters, der in dem ersten Modell enthalten ist, aus einem Modellsatz basierend auf dem Abtastdatensatz Folgendes umfasst:

      Erhalten, durch die erste Vorrichtung, eines ersten Datensatzes und eines zweiten Datensatzes aus dem Abtastdatensatz gemäß einem voreingestellten Algorithmus, wobei der erste Datensatz mindestens eines der Vielzahl von Abtastdatenstücken umfasst und der zweite Datensatz mindestens eines der Vielzahl von Abtastdatenstücken umfasst;
      Erhalten, durch die erste Vorrichtung, eines Wertes eines Parameters, der in einem zweiten Modell in dem Modellsatz enthalten ist, basierend auf dem ersten Datensatz, wobei das Erhalten, durch die erste Vorrichtung, eines Wertes eines Parameters, der in dem zweiten Modell enthalten ist, basierend auf dem ersten Datensatz, Folgendes umfasst: Trainieren des zweiten Modells unter Verwendung der im ersten Datensatz enthaltenen Abtastdaten, um den Wert des im zweiten Modell enthaltenen Parameters zu erhalten,
      Erhalten, durch die erste Vorrichtung, einer dem zweiten Modell entsprechenden Abweichung auf der Grundlage des zweiten Datensatzes und des Wertes des im zweiten Modell enthaltenen Parameters, wobei die dem zweiten Modell entsprechende Abweichung eine Summe der Differenzen zwischen den tatsächlichen Daten und den auf der Grundlage des zweiten Modells ermittelten vorausgesagten Daten ist, wobei die vorausgesagten Daten, die auf der Grundlage des zweiten Modells bestimmt werden, durch Eingabe der Abtastdaten, die in dem zweiten Datensatz enthalten sind, in das zweite Modell bestimmt werden; und,
      wenn die dem zweiten Modell entsprechende Abweichung kleiner als ein Voreinstellwert ist, Verwenden, durch die erste Vorrichtung, des zweiten Modells als das erste Modell, wobei der Wert des Parameters, der im ersten Modell enthalten ist, der Wert des Parameters ist, der im zweiten Modell enthalten ist.

2. Verfahren nach Anspruch 1, wobei, wenn die erste Vorrichtung eine Netzwerkverwaltungsvorrichtung und die zweite Vorrichtung eine Netzwerkvorrichtung ist, das Verfahren ferner Folgendes umfasst:
   Senden, durch die erste Vorrichtung, des ersten Modells an die zweite Vorrichtung.

3. Verfahren nach einem der Ansprüche 1 bis 2, wobei das Verfahren ferner Folgendes umfasst:
   Erhalten, durch die erste Vorrichtung, von abnormalen Abtastdaten in dem Abtastdatensatz, wobei die abnormalen Abtastdaten tatsächliche Daten und Daten als eine unabhängige Variable in dem ersten Modell umfassen; wobei die abnormalen Abtastdaten Abtastdaten sind, für die eine Abweichung zwischen den tatsächlichen Daten und den vorhergesagten Daten größer als ein zweiter Schwellenwert ist, wobei die vorhergesagten Daten auf der Grundlage der Daten als die unabhängige Variable und des ersten Modells erhalten werden.

4. Verfahren nach Anspruch 3, wobei das Erhalten, durch die erste Vorrichtung, von abnormalen Abtastdaten in dem Abtastdatensatz Folgendes umfasst:

   Empfangen, durch die erste Vorrichtung, der von der zweiten Vorrichtung gesendeten anormalen Abtastdaten, oder
   Erhalten, durch die erste Vorrichtung, der abnormalen Abtastdaten mittels Berechnung auf der Grundlage des zweiten Datensatzes und des zweiten Schwellenwertes.

5. Verfahren nach Anspruch 3 oder 4, wobei, wenn die erste Vorrichtung eine Netzwerkverwaltungsvorrichtung ist, das Verfahren ferner Folgendes umfasst:

Verwenden, durch die erste Vorrichtung, der tatsächlichen Daten, die in den abnormalen Abtastdaten enthalten sind, um die vorhergesagten Daten zu ersetzen, die auf der Grundlage der Daten als die unabhängige Variable in dem ersten Modell und des ersten Modells bestimmt werden.

6. Verfahren nach Anspruch 1 oder Anspruch 3 oder 4, wobei, wenn die erste Vorrichtung eine Netzwerkvorrichtung ist, das Verfahren ferner Folgendes umfasst:

Senden, durch die erste Vorrichtung, eines ersten Kandidatenmodellsatzes an die zweite Vorrichtung, wobei der erste Kandidatenmodellsatz ein Modell umfasst, das von der ersten Vorrichtung unterstützt wird, und Erhalten, durch die erste Vorrichtung, eines vierten Modells und einer Kennung des vierten Modells, die von der zweiten Vorrichtung gesendet wurde, wobei das vierte Modell und die Kennung des vierten Modells von der zweiten Vorrichtung auf der Grundlage eines zweiten Kandidatenmodellsatzes und des ersten Kandidatenmodellsatzes bestimmt werden; der zweite Kandidatenmodellsatz ein von der zweiten Vorrichtung unterstütztes Modell umfasst; und das vierte Modell ein Modell im Modellsatz ist, das mit der ersten Vorrichtung synchronisiert werden muss.

7. Verfahren nach einem der Ansprüche 1 bis 5, wobei, wenn die erste Vorrichtung eine Netzwerkverwaltungsvorrichtung ist, das Verfahren ferner Folgendes umfasst:

Erhalten, durch die erste Vorrichtung, eines ersten Kandidatenmodellsatzes, der von der zweiten Vorrichtung gesendet wurde, wobei der erste Kandidatenmodellsatz ein von der zweiten Vorrichtung unterstütztes Modell umfasst; und
Erhalten, durch die erste Vorrichtung, eines fünften Modells und einer Kennung des fünften Modells auf der Grundlage eines zweiten Kandidatenmodellsatzes und des ersten Kandidatenmodellsatzes, wobei der zweite Kandidatenmodellsatz ein Modell umfasst, das von der ersten Vorrichtung unterstützt wird, und das fünfte Modell ein beliebiges Modell im Modellsatz ist.

8. Vorrichtung, wobei die Vorrichtung als eine erste Vorrichtung verwendet wird und Folgendes umfasst:

ein erstes Erhaltungsmodul (901), das so ausgebildet ist, dass es einen Abtastdatensatz innerhalb einer voreingestellten Abtastperiode erhält, wobei der Abtastdatensatz eine Vielzahl von Abtastdatenstücken umfasst;
ein zweites Erhaltungsmodul (902), das so ausgebildet ist, dass es ein erstes Modell und einen Wert eines Parameters, der in dem ersten Modell enthalten ist, aus einem Modellsatz auf der Grundlage des Abtastdatensatzes erhält, wobei der Modellsatz ein oder mehrere Modelle umfasst, die sowohl von der ersten Vorrichtung als auch von einer zweiten Vorrichtung unterstützt werden; und
ein Sendemodul (903), das so ausgebildet ist, dass es eine Kennung des ersten Modells und den Wert des in dem ersten Modell enthaltenen Parameters an die zweite Vorrichtung sendet,
wobei das zweite Erhaltungsmodul (902) speziell für Folgendes ausgebildet ist:

Erhalten eines ersten Datensatzes und eines zweiten Datensatzes aus dem Abtastdatensatz nach einem voreingestellten Algorithmus, wobei der erste Datensatz mindestens eines der Vielzahl von Abtastdatenstücken umfasst und der zweite Datensatz mindestens eines der Vielzahl von Abtastdatenstücken umfasst;
Erhalten eines Wertes eines Parameters, der in einem zweiten Modell des Modellsatzes enthalten ist, auf der Grundlage des ersten Datensatzes, wobei das Erhalten des Wertes des Parameters, der in dem zweiten Modell enthalten ist, basierend auf dem ersten Datensatz Folgendes umfasst: Trainieren des zweiten Modells unter Verwendung der im ersten Datensatz enthaltenen Abtastdaten, um den Wert des im zweiten Modell enthaltenen Parameters zu erhalten,
Erhalten einer dem zweiten Modell entsprechenden Abweichung auf der Grundlage des zweiten Datensatzes und des Wertes des im zweiten Modell enthaltenen Parameters, wobei die dem zweiten Modell entsprechende Abweichung eine Summe der Differenzen zwischen den tatsächlichen Daten und den auf der Grundlage des zweiten Modells ermittelten vorausgesagten Daten ist, wobei die vorausgesagten Daten, die auf der Grundlage des zweiten Modells bestimmt werden, durch Eingabe der Abtastdaten, die in dem zweiten Datensatz enthalten sind, in das zweite Modell bestimmt werden; und,
wenn die dem zweiten Modell entsprechende Abweichung kleiner als ein Voreinstellwert ist, Verwenden des zweiten Modells als das erste Modell, wobei der Wert des Parameters, der im ersten Modell enthalten ist, der Wert des Parameters ist, der im zweiten Modell enthalten ist.

**9.** Vorrichtung nach Anspruch 8, wobei, wenn die Vorrichtung eine Netzwerkverwaltungsvorrichtung ist und die zweite Vorrichtung eine Netzwerkvorrichtung ist, das Sendemodul ferner für Folgendes ausgebildet ist:
Senden des ersten Modells an die zweite Vorrichtung.

**10.** Vorrichtung nach einem der Ansprüche 8 bis 9, wobei das zweite Erhaltungsmodul (902) ferner für Folgendes ausgebildet ist:
Erhalten von abnormalen Abtastdaten im Abtastdatensatz, wobei die abnormalen Abtastdaten tatsächliche Daten und Daten als unabhängige Variable in dem ersten Modell umfassen; die abnormalen Abtastdaten Abtastdaten sind, für die eine Abweichung zwischen den tatsächlichen Daten und den vorhergesagten Daten größer als ein zweiter Schwellenwert ist, wobei die vorhergesagten Daten auf der Grundlage der Daten als die unabhängige Variable und des ersten Modells erhalten werden.

**11.** Vorrichtung nach Anspruch 10, wobei das zweite Erhaltungsmodul (902) speziell für Folgendes ausgebildet ist:

Empfangen der von der zweiten Vorrichtung gesendeten abnormalen Abtastdaten, oder
Erhalten der abnormalen Abtastdaten durch Berechnung auf der Grundlage des zweiten Datensatzes und des zweiten Schwellenwertes.

**12.** Vorrichtung nach Anspruch 10 oder 11, wobei, wenn die Vorrichtung eine Netzwerkverwaltungsvorrichtung ist, das zweite Erhaltungsmodul (902) ferner speziell für Folgendes ausgebildet ist:
Verwenden der tatsächlichen Daten, die in den abnormalen Abtastdaten enthalten sind, um die vorhergesagten Daten zu ersetzen, die auf der Grundlage der Daten als die unabhängige Variable in dem ersten Modell und des ersten Modells bestimmt werden.

**13.** Vorrichtung nach Anspruch 8 oder Anspruch 10 oder 11, wobei, wenn die erste Vorrichtung eine Netzwerkvorrichtung ist, das zweite Erfassungsmodul (902) ferner für Folgendes ausgebildet ist:
Senden eines ersten Kandidatenmodellsatzes an die zweite Vorrichtung, und Erhalten eines vierten Modells und einer Kennung des vierten Modells, die von der zweiten Vorrichtung gesendet wurden, wobei der erste Kandidatenmodellsatz ein Modell umfasst, das von der ersten Vorrichtung unterstützt wird, das vierte Modell und die Kennung des vierten Modells von der zweiten Vorrichtung auf der Grundlage eines zweiten Kandidatenmodellsatzes und des ersten Kandidatenmodellsatzes bestimmt werden; der zweite Kandidatenmodellsatz ein von der zweiten Vorrichtung unterstütztes Modell umfasst; und das vierte Modell ein Modell im Modellsatz ist, das mit der ersten Vorrichtung synchronisiert werden muss.

**14.** Vorrichtung nach einem der Ansprüche 8 bis 12, wobei, wenn die erste Vorrichtung eine Netzwerkverwaltungsvorrichtung ist, das zweite Erfassungsmodul (902) ferner für Folgendes ausgebildet ist:

Erhalten eines ersten Kandidatenmodellsatzes, der von der zweiten Vorrichtung gesendet wurde, wobei der erste Kandidatenmodellsatz ein von der zweiten Vorrichtung unterstütztes Modell umfasst; und
Erhalten eines fünften Modells und einer Kennung des fünften Modells auf der Grundlage eines zweiten Kandidatenmodellsatzes und des ersten Kandidatenmodellsatzes, wobei der zweite Kandidatenmodellsatz ein Modell umfasst, das von der ersten Vorrichtung unterstützt wird, und das fünfte Modell ein beliebiges Modell im Modellsatz ist.

## Revendications

**1.** Procédé de communication de données, comprenant :

l'obtention (301), par un premier dispositif, d'un ensemble de données échantillonnées dans une période d'échantillonnage prédéfinie, l'ensemble de données échantillonnées comprenant une pluralité d'éléments de données échantillonnées ;
l'obtention (302), par le premier dispositif, d'un premier modèle et d'une valeur d'un paramètre compris dans le premier modèle à partir d'un ensemble de modèles basé sur l'ensemble de données échantillonnées, l'ensemble de modèles comprenant un ou plusieurs modèles pris en charge à la fois par le premier dispositif et un second dispositif ; et
l'envoi (303), par le premier dispositif, d'un identifiant du premier modèle et de la valeur du paramètre compris dans le premier modèle au second dispositif,

l'obtention (302), par le premier dispositif, d'un premier modèle et d'une valeur d'un paramètre compris dans le premier modèle à partir d'un ensemble de modèles basé sur l'ensemble de données échantillonnées comprenant :

l'obtention, par le premier dispositif, d'un premier ensemble de données et d'un second ensemble de données à partir de l'ensemble de données échantillonnées selon un algorithme prédéfini, le premier ensemble de données comprenant au moins un élément de la pluralité de données échantillonnées, et le second ensemble de données comprenant au moins un élément de la pluralité de données échantillonnées ;

l'obtention, par le premier dispositif, d'une valeur d'un paramètre compris dans un second modèle dans l'ensemble de modèles basé sur le premier ensemble de données, l'obtention, par le premier dispositif, d'une valeur d'un paramètre compris dans le second modèle basé sur le premier ensemble de données comprenant : l'entraînement du second modèle à l'aide des données échantillonnées comprises dans le premier ensemble de données pour obtenir la valeur du paramètre compris dans le second modèle ;

l'obtention, par le premier dispositif, d'un écart correspondant au second modèle basé sur le second ensemble de données et la valeur du paramètre compris dans le second modèle, l'écart correspondant au second modèle étant une somme des différences entre les données réelles et les données prédites déterminées sur la base du second modèle, les données prédites déterminées sur la base du second modèle étant déterminées par l'entrée des données échantillonnées comprises dans le second ensemble de données dans le second modèle ; et

lorsque l'écart correspondant au second modèle est inférieur à une valeur prédéfinie, l'utilisation, par le premier dispositif, du second modèle comme premier modèle, la valeur du paramètre compris dans le premier modèle étant la valeur du paramètre compris dans le second modèle.

2. Procédé selon la revendication 1, si le premier dispositif est un dispositif de gestion de réseau et le second dispositif est un dispositif de réseau, le procédé comprenant en outre :
l'envoi, par le premier dispositif, du premier modèle au second dispositif.

3. Procédé selon l'une quelconque des revendications 1 et 2, le procédé comprenant en outre :
l'obtention, par le premier dispositif, de données échantillonnées anormales dans l'ensemble de données échantillonnées, les données échantillonnées anormales comprenant des données réelles et des données en tant que variable indépendante dans le premier modèle ; les données échantillonnées anormales étant des données échantillonnées pour lesquelles un écart entre les données réelles et les données prédites est supérieur à un second seuil, les données prédites étant obtenues sur la base des données en tant que variable indépendante et du premier modèle.

4. Procédé selon la revendication 3, l'obtention, par le premier dispositif, de données échantillonnées anormales dans l'ensemble de données échantillonnées comprenant :

la réception, par le premier dispositif, des données échantillonnées anormales envoyées par le second dispositif ; ou

l'obtention, par le premier dispositif, des données échantillonnées anormales par un calcul basé sur le second ensemble de données et le second seuil.

5. Procédé selon la revendication 3 ou 4, si le premier dispositif est un dispositif de gestion de réseau, le procédé comprenant en outre :
l'utilisation, par le premier dispositif, des données réelles comprises dans les données échantillonnées anormales pour remplacer les données prédites qui sont déterminées sur la base des données en tant que variable indépendante dans le premier modèle et du premier modèle.

6. Procédé selon la revendication 1 ou la revendication 3 ou 4, si le premier dispositif est un dispositif de réseau, le procédé comprenant en outre :

l'envoi, par le premier dispositif, d'un premier ensemble de modèles candidats au second dispositif, le premier ensemble de modèles candidats comprenant un modèle pris en charge par le premier dispositif ; et

l'obtention, par le premier dispositif, d'un quatrième modèle et d'un identifiant du quatrième modèle envoyé par le second dispositif : le quatrième modèle et l'identifiant du quatrième modèle étant déterminés par le second dispositif sur la base d'un second ensemble de modèles candidats et du premier ensemble de modèles candidats ; le second ensemble de modèles candidats comprenant un modèle pris en charge par le second dispositif ; et le quatrième modèle étant un modèle de l'ensemble de modèles qui doit être synchronisé avec le premier dispositif.

**7.** Procédé selon l'une quelconque des revendications 1 à 5, si le premier dispositif est un dispositif de gestion de réseau : le procédé comprenant en outre :

l'obtention, par le premier dispositif, d'un premier ensemble de modèles candidats envoyé par le second dispositif, le premier ensemble de modèles candidats comprenant un modèle pris en charge par le second dispositif ; et

l'obtention, par le premier dispositif, d'un cinquième modèle et d'un identifiant du cinquième modèle sur la base d'un second ensemble de modèles candidats et du premier ensemble de modèles candidats ; le second ensemble de modèles candidats comprenant un modèle pris en charge par le premier dispositif, et le cinquième modèle étant n'importe quel modèle de l'ensemble de modèles.

**8.** Dispositif, le dispositif étant utilisé comme un premier dispositif et comprenant :

un premier module d'obtention (901), configuré pour obtenir un ensemble de données échantillonnées dans une période d'échantillonnage prédéfinie, l'ensemble de données échantillonnées comprenant une pluralité d'éléments de données échantillonnées ;

un second module d'obtention (902), configuré pour obtenir un premier modèle et une valeur d'un paramètre compris dans le premier modèle à partir d'un ensemble de modèles basé sur l'ensemble de données échantillonnées, l'ensemble de modèles comprenant un ou plusieurs modèles pris en charge à la fois par le premier dispositif et un second dispositif ; et

un module d'envoi (903), configuré pour envoyer un identifiant du premier modèle et la valeur du paramètre compris dans le premier modèle au second dispositif,

le second module d'obtention (902) étant spécifiquement configuré pour :

obtenir un premier ensemble de données et un second ensemble de données à partir de l'ensemble de données échantillonnées selon un algorithme prédéfini, le premier ensemble de données comprenant au moins un élément de la pluralité de données échantillonnées, et le second ensemble de données comprenant au moins un élément de la pluralité de données échantillonnées ;

obtenir une valeur d'un paramètre compris dans un second modèle de l'ensemble de modèles basé sur le premier ensemble de données, l'obtention de la valeur du paramètre compris dans le second modèle basé sur le premier ensemble de données comprenant : l'entraînement du second modèle à l'aide des données échantillonnées comprises dans le premier ensemble de données pour obtenir la valeur du paramètre compris dans le second modèle ;

obtenir un écart correspondant au second modèle basé sur le second ensemble de données et la valeur du paramètre compris dans le second modèle, l'écart correspondant au second modèle étant une somme des différences entre les données réelles et les données prédites déterminées sur la base du second modèle, les données prédites déterminées sur la base du second modèle étant déterminées en entrant les données échantillonnées comprises dans le second ensemble de données dans le second modèle ; et

lorsque l'écart correspondant au second modèle est inférieur à une valeur prédéfinie, utiliser le second modèle comme premier modèle, la valeur du paramètre compris dans le premier modèle étant la valeur du paramètre compris dans le second modèle.

**9.** Dispositif selon la revendication 8, si le dispositif est un dispositif de gestion de réseau et que le second dispositif est un dispositif de réseau, le module d'envoi étant en outre configuré pour :

envoyer le premier modèle au second dispositif.

**10.** Dispositif selon l'une quelconque des revendications 8 et 9, le second module d'obtention (902) étant en outre configuré pour :

obtenir des données échantillonnées anormales dans l'ensemble de données échantillonnées, les données échantillonnées anormales comprenant des données réelles et des données en tant que variable indépendante dans le premier modèle ; les données échantillonnées anormales étant des données échantillonnées pour lesquelles un écart entre les données réelles et les données prédites est supérieur à un second seuil, les données prédites étant obtenues sur la base des données en tant que variable indépendante et du premier modèle.

**11.** Dispositif selon la revendication 10, le second module d'obtention (902) étant spécifiquement configuré pour :

recevoir les données échantillonnées anormales envoyées par le second dispositif ; ou obtenir les données échantillonnées anormales par un calcul basé sur le second ensemble de données et le second seuil.

12. Dispositif selon la revendication 10 ou 11, si le dispositif est un dispositif de gestion de réseau, le second module d'obtention (902) étant en outre spécifiquement configuré pour :
utiliser les données réelles comprises dans les données échantillonnées anormales pour remplacer les données prédites qui sont déterminées sur la base des données en tant que variable indépendante dans le premier modèle et du premier modèle.

13. Dispositif selon la revendication 8 ou la revendication 10 ou 11, si le premier dispositif est un dispositif de réseau, le second module d'obtention (902) étant en outre configuré pour :
envoyer un premier ensemble de modèles candidats au second dispositif, et obtenir un quatrième modèle et un identifiant du quatrième modèle envoyés par le second dispositif, le premier ensemble de modèles candidats comprenant un modèle pris en charge par le premier dispositif ; le quatrième modèle et l'identifiant du quatrième modèle étant déterminés par le second dispositif sur la base d'un second ensemble de modèles candidats et du premier ensemble de modèles candidats ; le second ensemble de modèles candidats comprenant un modèle pris en charge par le second dispositif; et le quatrième modèle étant un modèle de l'ensemble de modèles qui doit être synchronisé avec le premier dispositif.

14. Dispositif selon l'une quelconque des revendications 8 à 12, si le premier dispositif est un dispositif de gestion de réseau, le second module d'obtention (902) étant en outre configuré pour :

obtenir un premier ensemble de modèles candidats envoyé par le second dispositif, le premier ensemble de modèles candidats comprenant un modèle pris en charge par le second dispositif ; et
obtenir un cinquième modèle et un identifiant du cinquième modèle sur la base d'un second ensemble de modèles candidats et du premier ensemble de modèles candidats, le second ensemble de modèles candidats comprenant un modèle pris en charge par le premier dispositif, et le cinquième modèle étant n'importe quel modèle de l'ensemble de modèles.

FIG. 1

FIG. 2

First device

Second device

301: Obtain a sampled-data set within a preset sampling period

302: Obtain a first model and a value of a parameter included in the first model from a model set based on the sampled-data set

303: An identifier of the first model and the value of the parameter included in the first model

FIG. 3

Network
management device

Network

Device 1　　　Device 2　　　Device n

Network device

FIG. 4

Network
management
device

Collector

Data analysis
result

Analyzer

Read data

Controller

Step 1

Step 2

Step 4

Step 5

Network

Network device

Step 3

Computer

FIG. 5

FIG. 6

FIG. 7

FIG. 8

FIG. 9

1000

Device

1022 — Central processing unit

Power supply — 1026

Operating system — 1041

Data — 1044

Application program — 1042

Storage medium — 1030

Memory — 1032

Wired or wireless network interface — 1050

Input/Output inter face — 1058

FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2002099821 A1

- EP 2045673 A2